# EUROPÄISCHE PATENTSCHRIFT

(11) **EP 1 769 569 B1**
(45) Veröffentlichungstag und Bekanntmachung des Hinweises auf die Patenterteilung: **24.02.2010**
(21) Anmeldenummer: 05759627.2
(22) Anmeldetag: 08.07.2005
(51) Int. Cl.: H03B 11/02

(54) **HOCHSPANNUNGSSCHALTER UND VERWENDUNG DESSELBEN BEI EINEM MIKROWELLENGENERATOR**
HIGH-VOLTAGE SWITCH AND USE THEREOF IN A MICROWAVE GENERATOR
INTERRUPTEUR HAUTE TENSION ET UTILISATION DE CET INTERRUPTEUR DANS UN GENERATEUR DE MICRO-ONDES

(30) Priorität: 19.07.2004 DE 102004034895
(43) Veröffentlichungstag der Anmeldung: 04.04.2007
(73) Patentinhaber: Diehl BGT Defence GmbH & Co.KG, 88662 Überlingen (DE)
(72) Erfinder: JÜRGEN, Urban, 91058 Erlangen (DE); GEOFFREY, Staines, San Diego 92111 (DE)
(74) Vertreter: Diehl Patentabteilung
(86) Internationale Anmeldenummer: PCT/EP2005/007426
(87) Internationale Veröffentlichungsnummer: WO 2006/008000

(56) Entgegenhaltungen:
- DE-A1- 4 235 329
- DE-B3- 10 313 045
- DE-B3- 10 313 286
- US-A- 4 198 590

## Beschreibung

Die Erfindung betrifft einen Hochspannungsschalter, insbesondere für einen Mikrowellengenerator, gemäß dem Oberbegriff des Anspruches 1.

In vielen Anwendungsbereichen, bei denen hohe Spannungen geschaltet werden müssen, kommen Hochspannungsschalter der eingangs genannten Art zum Einsatz, über die eine Kondensatorstruktur, die über die anliegende Hochspannung aufgeladen wird, entladen werden kann. Erreicht die Ladespannung die Durchschlagspannung der Funkenstrecke, die in ihrer Spannungsfestigkeit letztendlich vom verwendeten Dielektrikum abhängig ist, so erfolgt die Zündung des Lichtbogens, die Funkenstrecke wird leitend und die kapazitiv gespeicherte Energie kann entladen werden.

Ein Anwendungsbeispiel, bei dem ein Hochspannungspuls mit hoher Pulsenergie geschaltet werden soll; ist beispielsweise ein Mikrowellengenerator. Die Funktion eines solchen Generators beruht darauf, dass eine Hochspannungsquelle, etwa eine gemäß dem Prinzip der Marx'schen Stoßspannungsschaltung parallel aufgeladene und dann in Serie geschaltete Kondensatorbatterie, über die Funkenstrecken des Hochspannungsschalters entladen wird. Solch ein impulsartiger Entladungsvorgang führt zu einem steil einsetzenden und stark oszillierenden Stromfluss und damit zu einer entsprechend breitbandigen Abstrahlung eines Mikrowellenspektrums so hoher Energiedichte, dass in der Nähe eines solchen Mikrowellengenerators der Funkverkehr zumindest beeinträchtigt und eine elektron nische Schaltung insbesondere eingangsseitig gestört oder sogar zerstört werden kann.

Als Hochspannungsquelle kann auch ein explosivstoffgetriebener Hochspannungsgenerator eingesetzt werden, welcher im Vergleich mit herkömmlichen Hochspannungsgeneratoren einen einzelnen Hochspannungspuls mit extrem hoher Pulsenergie zur Verfügung stellen kann. Der über einen solchen explosionsgetriebenen Generator erzeugbare Ausgangspuls ist in der Lage, beispielsweise eine Kapazität von 2 nF auf eine Spannung von 1 MV aufzuladen, was einer Pulsenergie von 1 kJ entspricht.

Kondensatorstrukturen, wie sie beispielsweise bei den Mikrowellengeneratoren der beschriebenen Art zum Einsatz kommen, sind jedoch nicht in der Lage, derart hohe Energien zwischenzuspeichern bzw. als Hochleistungsmikrowellenpuls abstrahlen zu können. Zwar wäre es möglich, die Kondensatorkapazität und damit die Kapazität der Abstrahlantenne zu erhöhen. Dies führt aber zu einer Änderung des Resonanzverhaltens der Struktur, die Resonanzfrequenz sinkt, wobei gleichzeitig die notwendigen Antennen für eine effektive Abstrahlung sehr groß dimensioniert werden müssen, was nicht erwünscht ist. Ein weiterer limitierender Faktor ist die Spannungsfestigkeit der Funkenstrecke des Hochspannungsschalters, die die pulsformende Leitung der Resonatorantenne bei dem Mikrowellengenerator kurzschließt. Es kommen hier entweder Funkenstrecken mit einem gasförmigen oder flüssigen Dielektrikum zum Einsatz, wobei die Zündelektroden im Hinblick auf möglichst geringe Einschaltverluste in einem Abstand von ca. 2 mm zueinander positioniert sind. Zwar könnte durch eine Vergrößerung des Abstands die Spannungsfestigkeit erhöht werden, hierdurch steigen aber die Verluste, das effektiv abgestrahlte Mikrowellenfeld erhöht sich nicht. Alternativ zur Verwendung von flüssigen oder gasförmigen Dielektrika sind Funkenstrecken mit einem Festkörperdielektrikum bekannt. Diese besitzen eine deutlich höhere Durchschlagsspannung als dielektrische Flüssigkeiten oder Hochdruckgase, das heißt, die Haltespannung kann deutlich gesteigert werden, bis zu 1,5 - 2 MV. Solche Festkörper-Funkenstrecken zeigen beim Durchschlag eine sehr hohe Stromanstiegsrate und damit einhergehend geringe Eirischaitverluste. Nachteilig aber ist die Zerstörung des Festkörperdielektrikums beim Durchbruch, eine Selbstheilung ist - anders als bei flüssigen oder gasförgasförmigen Dielektrika - nicht möglich. Solche Festkörperdielektrikum-Schalter sind folglich lediglich zur einmaligen Entladung und damit zur einmaligen Pulsgabe verwendbar. Wenngleich sich jedoch mit solchen Festkörperdielektrikum-Schaltern die Haltespannung der Funkenstrecke bis in den MV-Bereich erhöhen lässt, ist es aus oben geschilderten Gründen dennoch nicht möglich, die beispielsweise von einem explosionsstoffgetriebenen Hochspannungsgenerator zur Verfügung gestellte extrem hohe Pulsenergie effektiv nutzen zu können.

Aus der DE 42 35 329 A1 ist eine Kurzschlusseinrichtung bekannt, welche sich insbesondere zum Löschen von Störlichtbögen in Niederspannungs-Schaltanlagen zur Verteilung elektrischer Energie eignet. Die Kurzschlusseinrichtung besteht dabei aus mindestens einem Schaltelement und mindestens einem Kurzschließer, wobei der Kurzschließer aus mindestens zwei Elektroden und aus stromführenden Teilen oder Bereichen besteht, wobei durch elektrodynamische Krafteinwirkung in Folge des sowohl in dem Schaltelement als auch in dem Kurzschließer direkt fließenden Stromes in den stromführenden Teilen oder Bereichen mindestens ein bewegbarer oder deformierbarer stromführender Bereich bzw. Teil gegen die Elektroden gedrückt und somit ein metallischer Kurzschluss erzeugt wird.

Aus der DE 103 13 045 B3 ist eine Schaltvorrichtung bekannt, die zum Auslösen bei Überspannung vorgesehen ist. Diese bekannte Schaltvorrichtung weist Funkenstrecken mit jeweils zwei Elektroden auf, die parallel geschaltet werden und die in jedem Parallelzweig mit einer seriell zur Funkenstrecke geschalteten Sicherung versehen sind. Die jeweilige Sicherung wird bei einem Durchschlag über die Funkenstrecke irreversibel zerstört. Die jeweilige Funkenstrecke kann ein gasförmiges Dielektrikum aufweisen.

Ein kompakter hochenergetischer Mikrowellengenerator ist in der US 5 489 818 beschrieben. Dieser bekannte Mikrowellengenerator weist einen Hohlraumresonator auf, der zwei sich gegenüberliegende Elektroden aufweist, die sehr schnell kurzgeschlossen werden, um einen hochenergetischen Mikrowellenpuls zu erzeugen. Im Hohlraumresonator befindet sich ein flüssiges Dielektrikum.

Aus der US 3 398 322 ist ein Hochspannungsschalter bekannt, der einen Spalt aufweist, in dem sich ein gasförmiges Dielektrikum wie Luft, N₂ oder SF₈, oder ein flüssiges Dielektrikum, wie ein dielektrisches Öl, oder ein festes Dielektrikum, wie Polyethylen oder Mylar, befindet.

Die DE 103 13 286 B3 offenbart einen Mikrowellengenerator mit mehreren selbstzünden den Funkenstreken zur Entladung von Hochspannung.

Die DE 35 87 679 T2 offenbart eine Sicherung mit einem Sicherungselement, das sich zwischen zwei Anschlüssen in einem Gehäuse erstreckt und mindestens zwei parallel geschaltete Leiter und mindestens einen Kern aus Isolationsmaterial aufweist. Dabei kann ein Leiter eine Glasfaser und ein Leiter ein Kupferdraht sein. Der Kupferdraht kann bspw. Einen

Durchmesser von 25 um oder 50 um besitzen. Der Durchmesser des jeweiligen Kupferdrahtes und die Kombination von Kupferdrähten mit Glasfasern hängt vom Nennstrom der Sicherung und von dem gewünschten Ansprechverhalten der Sicherung ab.

Der Erfindung liegt die Aufgabe zugrunde, einen Funkenstrecken-Hochspannungsschalter der eingangs genannten Art zu schaffen, der überall dort eingesetzt werden kann, wo hohe Energien geschaltet werden sollen, insbesondere, jedoch nicht beschränkend und in Verbindung mit einem Mikrowellengenerator.

Diese Aufgabe wird erfindungsgemäß durch die Merkmale des Anspruches 1 gelöst. Bevorzugte Aus- bzw. Weiterbildungen des erfindungsgemäßen Hochspannungsschalters sind in den Unteransprüchen gekennzeichnet.

Über die parallel geschalteten Funkenstrecken ist eine mehrfache Entladung der Kapazität und damit eine Aufteilung der gesamten, von der Einzelpuls-Hochspannungsquelle gegebenen Energie in mehrere Pulse möglich. Von den mehreren parallel geschalteten Funkenstrecken wird bei Erreichen der streckenspezifischen Durchschlagsspannung zunächst die "schwächste" Funkenstrecke zünden, es kommt zu einer ersten Teilentladung. Aufgrund der zur jeweiligen Funkenstrecke seriell geschalteten Sicherung, die beim Durchschlag irreversibel zerstört wird, wird verhindert, dass bei einer weiteren Aufladung der Kapazität der pulsformenden Leitung erneut über diese Funkenstrecke ein Durchschlag erfolgen kann, der bei einer wesentlich niedrigeren Spannung erfolgen würde, nachdem die Spannungsfestigkeit aufgrund der unmittelbar vorausgehenden Zündung nicht mehr der ursprünglichen entspricht. Vielmehr ist es möglich, die jeweilige Kapazität soweit aufzuladen, bis die Haltespannung die Spannungsfestigkeit der "nächstschwächeren" Funkenstrecke erreicht, so dass diese zündet, gleichwohl aber ebenfalls aufgrund der beim Zünden durchbrennenden Sicherung unmittelbar damit einhergehend abgekoppelt wird. Auf diese Weise kann eine quasi kaskadenförmige Entladung in Form mehrerer Teilpulse realisiert werden, so dass die hohe, von der Spannungsquelle gegebene Energie effektiv in Form mehrerer Einzelpulse genutzt werden kann.

Die jeweilige Funkenstrecke des erfindungsgemäßen Hochspannungsschalters kann als Dielektrikum ein flüssiges oder gasförmiges Medium enthalten. Wenngleich solche Dielektrika ein Selbstheilungsverhalten zeigen, ist der Selbstheilungsprozess jedoch - im Hinblick auf die Geschwindigkeit der Aufladung der Kondensatorstruktur - ein relativ langsamer Prozess. Das heißt, dass der bei dem vorangehenden Durchschlag erzeugte ionisierte Kanal durch das Dielektrikum noch nicht vollständig abgebaut ist, wenn die Aufladespannung die aufgrund der Restionisierung nach wie vor reduzierte Spannungsfestigkeit der bereits gezündeten Funkenstrecke wieder erreicht. Es käme also zu einem wesentlich früheren, unkontrollierten zweiten Durchschlag. Infolge der irreversibel zerstörten Sicherung ist ein solcher jedoch nicht mehr möglich, wohl aber über eine der parallelen Funkenstrecken. Der zweite Entladungsvorgang kann also wesentlich schneller vonstatten gehen, als dies bei Funkenstrecken mit flüssigen oder gasförmigen Dielektrika ohne den Einsatz der erfindungsgemäßen Sicherung möglich wäre.

Alternativ zur Verwendung derartiger Dielektrika kann die Funkenstrecke natürlich zumindest zum Teil auch aus einem Festkörper-Dielektrikum, beispielsweise einem Epoxidharz, bestehen. Um diskrete, definierte Entladestrecken zu realisieren, ist es zweckmäßig, wenn jede Funkenstrecke mittels zweier diskreter Elektroden gebildet ist, das heißt, jeder über die Sicherung gesicherten Elektrode liegt eine zweite diskrete Elektrode gegenüber.

In fertigungstechnischer Sicht ist es zweckmäßig, wenn ein Isolatorträger mit mehreren voneinander getrennten Kanälen vorgesehen ist, in denen jeweils zumindest die erste Elektrode, vorzugsweise beide Elektroden und die Sicherung aufgenommen ist. Dieser Isolatorträger, der beispielsweise bei Verwendung eines Festkörperdielektrikums aus dem gleichen Material, gegebenenfalls mit den kanalseitigen Dielektrika einstückig gefertigt ist, weist mehrere diskrete Kanäle, die die Funkenstrecke enthalten bzw. die diese definieren, auf. In den Kanälen ist jeweils zumindest die erste Elektrode gehaltert. Zweckmäßigerweise erstreckt sich der Isolatörträger zwischen den Kondensatorflächen, zwischen denen der Durchschlag erfolgen soll, so dass bevorzugt sämtliche Elektroden wie auch die Sicherungen in den Kanälen aufgenommen sind, wobei die jeweiligen Kanäle bevorzugt über die gesamte Länge voneinander getrennt sind.

Als Sicherung kann beispielsweise eine Drahtsicherung, insbesondere ein Cu-Draht verwendet werden, der bevorzugt einen Durchmesseer ≤ 100 µm, insbesondere zwischen 5 µm und 25 µm und einer Länge ≤ 15 cm, insbesondere zwischen 5 cm und 10 cm aufweist. Im Hinblick darauf, dass über die Sicherung nur ein einziger Spannungspuls gegeben wird und ein sehr kurzer Entladestrom fließt, ist es möglich, einen derart dünnen Draht zu verwenden. Die Sicherung ist so auszulegen, dass das Durchbrennen in etwa mit dem gewünschten Entladevorgang korreliert.

Wie beschrieben ermöglicht der erfindungsgemäße Hochspannungsschalter eine Kaskadierung der spannungsabhängigen Durchschlagszeitpunkte. Diese unterschiedlichen Durchschlagszeitpunkte können aus Fertigungstoleranzen resultieren, nachdem naturgemäß die Funkenstrecken in ihrer Spannungsfestigkeit nicht alle absolut identisch ausgeführt werden können. In diesem Fall wäre also die Zündungsreihenfolge letztlich zufällig. Um die Zündreihenfolge - und damit natürlich auch die jeweiligen streckenspezifischen Spannungsfestigkeiten - definiert einstellen zu können, sieht eine Weiterbildung der Erfindung vor, zur Kaskadierung der Durchschlagzeitpunkte die Abstände der Elektroden der jeweiligen Funkenstrecken unterschiedlich oder bei Verwendung von Festkörper-Dielektrika die Dicke der Dielektrika im Bereich zwischen den Elektroden unterschiedlich zu bemessen. Gemäß dieser Erfindungsausgestaltung wird also konstruktiv Einfluss auf den Zündvorgang genommen.

Die Funkenstrecken selbst können in reihenförmiger oder in ringförmiger Anordnung vorgesehen sein, je nachdem, wie die Kondensatoranordnung selbst ausgelegt ist.
Verwendung kann der erfindungsgemäße Hochspannungsschalter vorzugsweise bei einem Mikrowellengenerator finden, der wenigstens einen Ladungsspeicher aufweist, der mit einem zugehörigen Hochspannungsschalter in Serie geschaltet ist, wobei der Ladungsspeicher über den jeweiligen Hochspannungsschalter zum Abstrahlen von Mikrowellen entladbar ist.

Weitere Einzelheiten der Erfindung ergeben sich aus den im folgenden beschriebenen Ausführungsbeispielen sowie anhand der Zeichnungen. Dabei zeigen:
- Fig. 1: eine Prinzipskizze eines erfindungsgemäßen Mikrowellengenerators,
- Fig. 2: eine Prinzipskizze eines erfindungsgemäßen Hochspannungsschalters, wie er bei dem Mikrowellengenerator aus Fig. 1 verwendet werden kann,
- Fig. 3: eine Prinzipdarstellung des zeitlichen Spannungsverlaufs und der abgestrahlten Mikrowellenpulse bei Verwendung eines erfindungsgemäßen Hochspannungsschalters bei einem Mikrowellengenerator,
- Fig. 4: eine Prinzipdarstellung einer zweiten Ausführungsform eines erfindungsgemäßen Hochspannungsschalters, und
- Fig. 5: eine Prinzipdarstellung einer dritten Ausführungsform eines erfindungsgemäßen Hochspannungsschalters.

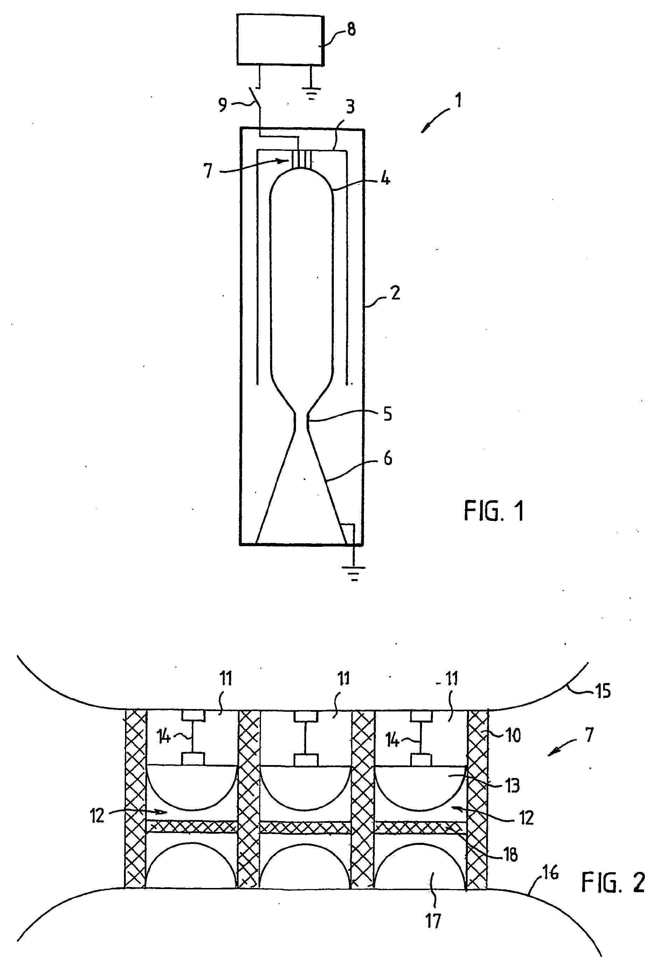

Fig. 1 zeigt als nicht limitierende Prinzipdarstellung einen erfindungsgemäßen Mikrowellengenerator 1, bestehend aus einem hohlzylindrischen Gehäuse 2 aus einem elektrisch isolierenden Material. In diesem sind zwei Elektroden 3, 4 vorgesehen, wobei die Elektrode 3 im Wesentlichen topfartig und zylindrisch ist, während die Elektrode 4 hohlkugelkappenförmig ist. Die Elektrode 4 stellt gewissermaßen den ausgebauchten Boden einer im Übrigen bauchigen, flaschenförmigen Elektrode innerhalb der sie umgebenden topfförmigen Elektrode dar. Die flaschenhalsförmige Verjüngung 5 schließt an die schmale Basis des spitzwinklig höhlkegelstumpfförmigen Strahlers 6 an, der infolge dieser Trichterform zugleich als Impedanzwandler für das Abstrahlverhalten des Hochfrequenzgemisches wirkt, wenn die beiden Elektroden 3, 4 zum Entladen über den Hochspannungsschalter 7 kurzgeschlossen werden. Die gesamte Anordnung ist rotationssymmetrisch. Die Elektroden 3, 4 bilden eine Kondensatorstruktur und damit einen Ladungsspeicher, der über eine Hochspannungsquelle 8 aufgeladen werden kann. Die Hochspannungsquelle 8, bei der es sich beispielsweise um einen explosionsstoffgetriebenen Hochspannungsgenerator handeln kann, ist über einen Schalter 9 mit der Elektrode 3 verbunden, die beim Schließen des Schalters 9 aufgeladen wird. Erreicht die Ladespannung die Spannungsfestigkeit einer im Hochspannungsschalter 7 vorgesehenen Funkenstrecke, so schlägt diese durch, es kommt also zur Zündung und damit zum Kurzschluss der Elektroden 3, 4, wodurch kräftige oszillierende Kurzschlussströme aufgrund des Entladevorgangs des Ladungsspeichers, also der Elektrode 3, oszillieren und der Strahler 6, also die Antenne einen Mikrowellenpuls emittiert.

Nachdem die Hochspannungsquelle 8, insbesondere in Form eines explosionsgetriebenen Generators, wesentlich mehr Energie zur Verfügung stellt, als über den Strahler 6 abgestrahlt werden kann, kommt ein erfindungsgemäß ausgebildeter Hochspannungsschalter 7 zum Einsatz, wie er beispielsweise in Fig. 2 gezeigt ist. Der dort gezeigte Hochspannungsschalter 7 besitzt einen lsolatorträger 10, in dem mehrere Kanäle 11 vorgesehen sind, in denen die Funkenstrecken 12 ausgebildet sind. In jedem Kanal 11 ist eine erste Elektrode 13 vorgesehen, die über eine Sicherung 14 in Form eines Drahtes mit einer Elektrode 15, beispielsweise der Elektrode 3 in Fig. 1, gekoppelt ist. Der halbkugelförmigen Elektrode 13 gegenüberliegend ist an einer Gegenelektrode 16, die beispielsweise der Elektrode 4 in Fig. 1 entspricht, jeweils eine zweite, ebenfalls halbkugelförmige Elektrode 17 positioniert. Zwischen beiden befindet sich die Funkenstrecke 12, die mit einem Dielektrikum gefüllt ist. Bei der in Fig. 2 gezeigten Ausführungsform ist ein Festkörperdielektrikum 18 vorgesehen, das beispielsweise einstückig mit dem lsolierstoffträger 10 und aus demselben Material, z.B. Epoxydharz, gefertigt sein kann. Der restliche Raum im jeweiligen Kanal 11 kann beispielsweise mit einem Isoliergas gefüllt sein.

Die Spannungsfestigkeit jeder Funkenstrecke 12 ist über die Spannungsfestigkeit des jeweiligen Dielektrikums 18 bestimmt. Wird nun die Elektrode 15 bzw. ausgehend von Fig. 1 die Elektrode 3 aufgeladen, so werden gleichermaßen die Elektroden 13 aufgeladen. Zwischen diesen Elektroden 13 und den zweiten, gegenüberliegenden Elektroden 17, die geerdet sind, bildet sich eine Potentialdifferenz aus. Erreicht die Ladespannung die Durchschlagsspannung derjenigen Funkenstrecke 12, die die niedrigste Spannungsfestigkeit besitzt, so wird diese Funkenstrecke zuerst zünden. Ausgehend von Fig. 2 sei angenommen, dass die in dieser Figur links gezeigte Funkenstrecke 12 die "schwächste" Funkenstrecke ist, was beispielsweise aus Fertigungstoleranzen zurückzuführen ist, oder gezielt durch entsprechende Variierung des Abstands der Elektroden 13 und 17 zueinander über die jeweiligen Funkenstrecken oder durch Variierung des Durchmessers des Festkörperdielektrikums 18 eingestellt werden kann. Im Falle des Durchschlags zündet ein Lichtbogen zwischen den beiden Elektroden 13 und 17 der linken Funkenstrecke 12, es kommt zur Entladung der Kondensatorstruktur und damit zur Einleitung eines kräftigen Kurzschlussstroms in die Elektrode 16, die mit dem Mikrowellenstrahler gekoppelt ist, der dann die Mikrowellen abstrahlt.

Während des Durchschlags wird die Sicherung 14 irreversibel zerstört, das heißt, der Sicherungsdraht wird unterbrochen, die Elektrode 13 ist damit mit der Elektrode 15 nicht mehr gekoppelt. Die übrigen Funkenstrecken 12 bleiben unbeschädigt, da sie nicht zünden. Bei einer weiteren Aufladung der Kapazität, gebildet über die pulsformende Leitung, die an der Elektrode 15 anliegt, kann aufgrund der Zerstörung der Sicherung 14 der bereits gezündeten Funkenstrecke 12 diese nicht mehr auslösen. Ein zweiter Durchbruch ist aber über eine der verbliebenen Funkenstrecken 12 möglich, und zwar über diejenige, die die nächsthöhere Spannungsfestigkeit aufweist. Schlägt nun im gezeigten Ausführungsbeispiel die mittlere Funkenstrecke 12 durch, so kommt es auch hier zu einer Entladung der Kapazität und zur Abstrahlung eines Mikrowellenpulses, gleichzeitig wird aber auch hier die Sicherung 14 irreversibel zerstört. Bei einer weiteren Aufladung kann dann ein weiterer Durchschlag über die dritte Funkenstrecke 12 erfolgen, wobei natürlich wesentlich mehr als die gezeigten drei Funkenstrecken vorgesehen sein können.

Es erfolgt also unter Verwendung des erfindungsgemäßen Schalters eine mehrmalige Auf- und Entladung der Kapazität und die Abstrahlung mehrerer Mikrowellenpulse, das heißt, ein einziger hochenergetischer Ausgangspuls einer Einzelpuls-Hochspannungsquelle wird in mehrere Teilpulse zerlegt, was allein über das Schaltverhalten des Hochspannungsschalters 7 realisiert wird.

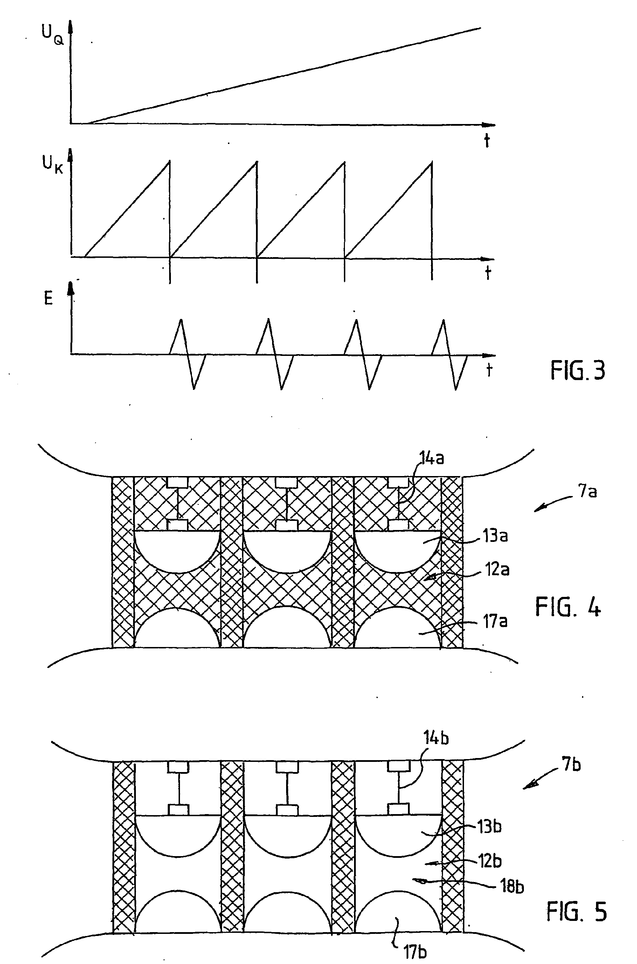

Fig. 3 zeigt in Form dreier Diagramme, die als Prinzipskizze jedoch nicht die tatsächlichen Spannungshöhen und Spannungsverhältnisse zueinander darstellt, die zeitlichen Spannungs- und Pulsverläufe. Die obere Kurve zeigt den zeitlichen Spannungsverlauf einer Einzelschuss-Hochspannungsquelle, wie beispielsweise eines explosionsgetriebenen Hochspannungsgenerators, an einer großen Lastkapazität. Die Spannung und damit die Energie wird in Form eines einzigen Pulses übertragen. Die mittlere Kurve zeigt die Spannungsverhältnisse an der aufgeladenen Kondensatorstruktur. Ersichtlich wird diese zunächst schnell aufgeladen, bis die Kondensatorspannung die Spannungsfestigkeit der ersten Funkenstrecke erreicht und es zum Durchschlag und mithin zur Entladung der Kondensatorstruktur kommt, was sich in der steil abfallenden Kondensatorspannung äußert. Zeitgleich kommt es, wie in der unteren Kurve dargestellt ist, zur Abstrahlung des entladungsbedingt erzeugten Mikrowellenpulses. Unmittelbar nach dem Entladen erfolgt die erneute Aufladung oder Kondensatorstruktur, nachdem der von der Hochspannungsquelle gegebene Spannungspuls nach wie vor anliegt. Bei Erreichen der Durchschlagsspannung der zweiten Funkenstrecke kommt es erneut zum Durchschlag und zur Entladung und zur Abstrahlung eines zweiten Mikrowellenpulses, und so weiter. Dies geht so lange, bis die Hochspannungsquelle die Kondensatorstruktur entweder nicht mehr lädt, oder bis sämtliche Funkenstrecken gezündet haben und infolgedessen kein Durchschlag mehr möglich ist.

Fig. 4 zeigt in Form einer Prinzipskizze eine weitere Ausführungsform eines erfindungsgemäßen Hochspannungsschalters 7a, bei dem jedoch die Elektroden 13a, 17a sowie die Sicherungen 14a vollständig in Isoliermaterial, das gleichzeitig das Dielektrikum für die Funkenstrecken 12a bildet, eingegossen ist. Das Funktionsprinzip ist jedoch das gleiche wie bezüglich des Hochspannungsschalters 7 aus Fig. 2 beschrieben.

Demgegenüber zeigt Fig. 5 eine dritte Ausführungsform eines erfindungsgemäßen Hochspannungsschalters 7b. Dieser entspricht im Wesentlichen dem Hochspannungsschalter 7 aus Fig. 2, jedoch kommt dort kein Festkörperdielektrikum, sondern ausschließlich ein gasförmiges Dielektrikum 18b in der Funkenstrecke 12b zum Einsatz. Denkbar wäre auch die Verwendung eines flüssigen Dielektrikums. Zwar zeigen diese Dielektrika eine Selbstheilung und damit die Möglichkeit zur Wiedererlangung der Spannungsfestigkeit nach einem vorangehenden Durchbruch, jedoch ist eine zweite Zündung infolge der Zerstörung der jeweiligen Sicherung 14b nicht möglich. Da jedoch weitere Funkenstrecken 12b zur Verfügung stehen, kann eine wesentlich schnellere weitere Zündung erfolgen.

Wie bereits beschrieben ist der Einsatz eines erfindungsgemäßen Hochspannungsschalters nicht auf dem Bereich der Mikrowellengeneratoren begrenzt. Vielmehr ist der erfindungsgemäße Hochspannungsschalter überall dort einsetzbar, wo hochenergetische Pulse, insbesondere Einzelpulse, zu schalten sind, beispielsweise im Bereich der Ansteuerung und Erzeugung von Laserpulsen etc.

## Patentansprüche

1. Hochspannungsschalter, insbesondere für einen Mikrowellengenerator, umfassend eine Hochspannungsquelle (8) und mehrere Funkenstrecken (12, 12a, 12b) mit jeweils zwei Elektroden (13, 13a, 13b; 17, 17a, 17b), **dadurch gekennzeichnet, dass** zu jeder Funkenstrecke (12, 12a, 12b) eine Sicherung (14, 14a, 14b) in Serie geschaltet ist und diese Serienschaltungen in einer Parallelschaltung miteinander verbunden sind,
dass jede Sicherung (14, 14a, 14b) eingerichtet ist, nach dem Zünden ihrer zugehörigen Funkenstrecke (12, 12a, 12b) durchzubrennen, wodurch die zugehörige Funkenstrecke (12, 12a, 12b) von der Spannungsquelle (8) abgetrennt wird, was die Zündung einer anderen Funkenstrecke (12, 12a, 12b) ermöglicht, wodurch eine kaskadenförmige Entladung über mehrere. Teilpulse über die Funkenstrecken (12, 12a, 12b) ermöglicht wird.

2. Hochspannungsschalter nach Anspruch 1,
**dadurch gekennzeichnet,**
**dass** die Funkenstrecke (12b) ein flüssiges oder gasförmiges Dielektrikum (18b) aufweist.

3. Hochspannungsschalter nach Anspruch 1,
**dadurch gekennzeichnet,**
**dass** die Funkenstrecke zumindest zum Teil aus einem Festkörper-Dielektrikum (18) besteht.

4. Hochspannungsschalter nach einem der vorangehenden Ansprüche,
**dadurch gekennzeichnet,**
**dass** sich die beiden Elektroden (13, 13a, 13b und 17, 17a, 17b) gegenüberliegen und durch die zugehörige Funkenstrecke (12, 12a, 12b) voneinander beabstandet sind.

5. Hochspannungsschalter Anspruch 4,
**dadurch gekennzeichnet,**
**dass** ein Isolatorträger (10) mit mehreren voneinander getrennten Kanälen (11) vorgesehen ist, in denen jeweils zumindest die erste Elektrode (13, 13a, 13b), vorzugsweise beide Elektroden (17, 17a, 17b) und die Sicherung (14, 14a, 14b) aufgenommen ist.

6. Hochspanhungsschalter nach einem der vorangehenden Ansprüche,
**dadurch gekennzeichnet,**
**dass** die Sicherung (14, 14a, 14b) eine Drahtsicherung, insbesondere ein Cu-Draht ist.

7. Hochspannungsschalter nach Anspruch 6,
**dadurch gekennzeichnet,**
**dass** der Draht einen Durchmessers 100 µm, insbesondere zwischen 5 µm und 25 µm, und eine Lange ≤ 15 cm, insbesondere zwischen 5 cm und 10 cm, aufweist.

8. Hochspannungsschalter nach einem der Ansprüche 1 bis 7,
**dadurch gekennzeichnet,**
**dass** zur Kaskadierung der spannungsabhängigen Durchschlagzeitpunkte die Funkenstrecken (12, 12a, 12b) unterschiedlich lang sind.

9. Hochspannungsschalter nach einem der Ansprüche 2 bis 7,
**dadurch gekennzeichnet,**
**dass** bei Verwendung von Festkörper-Dielektrika die Dicke der Dielektrika (8) unterschiedlich ist.

10. Hochspannungsschalter nach einem der vorangehenden Ansprüche,
**dadurch gekennzeichnet,**
**dass** die Funkenstrecken (12, 12a, 12b) in reihenförmiger oder ringförmiger Anordnung vorgesehen sind.

11. Verwendung eines Hochspannungsschalters (7) nach einem der Ansprüche 1 bis 10 bei einem Mikrowellengenerator der wenigstens einen Ladungsspeicher aufweist, der mit einem zugehörigen Hochspannungsschalter (7) in Serie geschaltet ist, wobei der Ladungsspeicher über den jeweiligen Hochspannungsschalter (7) zum Abstrahlen von Mikrowellen entladbar ist.

## Claims

1. High-voltage switch, in particular for a microwave generator, having a high-voltage source (8) and a plurality of spark gaps (12, 12a, 12b) each having two electrodes (13, 13a, 13b; 17, 17a, 17b), **characterized in that** a fuse (14, 14a, 14b) is connected in series with each spark gap (12, 12a, 12b), and with these series circuits being connected to one another in a parallel circuit,
that each fuse (14, 14a, 14b) is arranged to blow after triggering its associated spark gap (12, 12a, 12b), thus disconnecting the associated spark gap (12, 12a, 12b) from the voltage source (8), which allows the triggering of another spark gap (12, 12a, 12b), thus allowing the discharge, in the form of a cascade, of a plurality of pulse elements across the spark gaps (12, 12a, 12b).

2. High-voltage switch according to Claim 1,
**characterized in that**
the spark gap (12b) has a liquid or gaseous dielectric (18b).

3. High-voltage switch according to Claim 1,
**characterized in that**
the spark gap is at least partially composed of a solid dielectric (18).

4. High-voltage switch according to one of the preceding claims,
**characterized in that**
the two electrodes (13, 13a, 13b and 17, 17a, 17b) are opposite one another and are separated from one another by the associated spark gap (12, 12a, 12b).

5. High-voltage switch according to Claim 4,
**characterized in that**
an isolator mount (10) is provided having a plurality of channels (11) which are isolated from one another and in each of which at least the first electrode (13, 13a, 13b) and preferably both electrodes (17, 17a, 17b) and the fuse (14, 14a, 14b) are accommodated.

6. High-voltage switch according to one of the preceding claims,
**characterized in that**
the fuse (14, 14a, 14b) is a wire fuse, in particular a copper wire.

7. High-voltage switch according to Claim 6,
**characterized in that**
the wire has a diameter of ≤ 100 µm, in particular between 5 µm and 25 µm, and a length of ≤ 15 cm, in particular between 5 cm and 10 cm.

8. High-voltage switch according to one of Claims 1 to 7,
**characterized in that**,
in order to cascade the voltage-dependent flashover times, the spark gaps (12, 12a, 12b) have different lengths.

9. High-voltage switch according to one of Claims 2 to 7,
**characterized in that**,
when using solid dielectrics, the thickness of the dielectrics (8) is different.

10. High-voltage switch according to one of the preceding claims,
**characterized in that**
the spark gaps (12, 12a, 12b) are arranged in a row or a ring.

11. Use of a high-voltage switch (7) according to one of Claims 1 to 10 for a microwave generator which has at least one charge store which is connected in series with an associated high-voltage switch (7), in which case the charge store can be discharged via the respective high-voltage switch (7) in order to emit microwaves.

## Revendications

1. Commutateur à haute tension, notamment pour un générateur de microondes, comprenant une source de haute tension (8) et plusieurs distances de décharge (12, 12a, 12b) respectivement munies de deux électrodes (13, 13a, 13b ; 17, 17a, 17b), **caractérisé en ce qu'**un fusible (14, 14a, 14b) est branché en série avec chaque distance de décharge (12, 12a, 12b) et ces circuits série sont reliés entre eux en un circuit parallèle, que chaque fusible (14, 14a, 14b) est conçu pour fondre après l'amorçage de la distance de décharge (12, 12a, 12b) qui lui est associée, la distance de décharge (12, 12a, 12b) associée se trouvant ainsi isolée de la source de tension (8), ce qui permet l'amorçage d'une autre distance de décharge (12, 12a, 12b) et permet ainsi une décharge en cascade sur plusieurs impulsions partielles par le biais des distances de décharge (12, 12a, 12b).

2. Commutateur à haute tension selon la revendication 1, **caractérisé en ce que** la distance de décharge (12b) présente un diélectrique liquide ou gazeux (18b).

3. Commutateur à haute tension selon la revendication 1, **caractérisé en ce que** la distance de décharge se compose au moins partiellement d'un diélectrique à corps solide (18).

4. Commutateur à haute tension selon l'une des revendications précédentes, **caractérisé en ce que** les deux électrodes (13, 13a, 13b et 17, 17a, 17b) sont opposées et sont espacées l'une de l'autre par la distance de décharge (12, 12a, 12b) associée.

5. Commutateur à haute tension selon la revendication 4, **caractérisé en ce qu'**il est prévu un porte-isolateur (10) comprenant plusieurs canaux (11) séparés les uns des autres dans lesquels sont respectivement logées au moins la première électrode (13, 13a, 13b), de préférence les deux électrodes (17, 17a, 17b) et le fusible (14, 14a, 14b).

6. Commutateur à haute tension selon l'une des revendications précédentes, **caractérisé en ce que** le fusible (14, 14a, 14b) est un fusible à fil, notamment un fil en cuivre.

7. Commutateur à haute tension selon la revendication 6, **caractérisé en ce que** le fil présente un diamètre ≤ 100 µm, notamment compris entre 5 µm et 25 µm, et une longueur ≤15 cm, notamment comprise entre 5 cm et 10 cm.

8. Commutateur à haute tension selon l'une des revendications 1 à 7, **caractérisé en ce que** les distances de décharge (12, 12a, 12b) ont des longueurs différentes pour la mise en cascade des moments de claquage dépendant de la tension.

9. Commutateur à haute tension selon l'une des revendications 2 à 7, **caractérisé en ce qu'**en cas d'utilisation de diélectriques à corps solide, l'épaisseur des diélectriques (8) est différente.

10. Commutateur à haute tension selon l'une des revendications précédentes, **caractérisé en ce que** les distances de décharge (12, 12a, 12b) sont prévues selon une disposition en ligne ou en anneau.

11. Utilisation d'un commutateur à haute tension (7) selon l'une des revendications 1 à 10 pour un générateur de microondes qui présente au moins un accumulateur de charge qui est branché en série avec un commutateur à haute tension (7) associé, l'accumulateur de charge pouvant être déchargé par le biais du commutateur à haute tension (7) correspondant afin d'irradier des microondes.
